(19) Europäisches Patentamt
European Patent Office
Office européen des brevets

(11) **EP 4 435 453 A1**

(12) **EUROPEAN PATENT APPLICATION**

(43) Date of publication:
**25.09.2024  Bulletin 2024/39**

(51) International Patent Classification (IPC):
**G01R 31/392** *(2019.01)*    **G01R 31/36** *(2020.01)*

(21) Application number: **23164181.2**

(22) Date of filing: **24.03.2023**

(52) Cooperative Patent Classification (CPC):
**G01R 31/3644; G01R 31/392**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Zilinská Univerzita V Ziline**
**010 26 Zilina (SK)**

(72) Inventors:
- **Prazenica, Michal**
  **018 26 Plevnik (SK)**
- **Simcak, Marek**
  **058 01 Poprad (SK)**
- **Frivaldsky, Michal**
  **013 42 Horny Hricov (SK)**

(74) Representative: **Wörz, Volker Alfred**
**Wörz Patentanwälte PartG mbB**
**Gablenberger Hauptstraße 32**
**70186 Stuttgart (DE)**

(54) **APPARATUS FOR IDENTIFYING THE PARAMETERS OF A SUBSTITUTE ELECTRICAL SCHEME OF ACCUMULATORS AND THE METHOD FOR IDENTIFYING**

(57)   Apparatus for identifying parameters of a substitute electrical scheme of accumulators contains a measuring chamber (1), a programmable power supply (7), a programmable load (8), a control system (9), and a computing unit (14),

while the computing unit (14) is equipped for operator access to set the parameters of the testing process, to monitor the status of the testing, and to access the results of the testing, the video recording of the testing, as well as other data about the testing apparatus and the accumulator under test (4);

and the measuring chamber (1) contains a disconnector (2) for charging and a disconnector (3) for discharging between which a accumulator under test (4) is placed connected thereto by power wires (15), and the accumulator under test (4) is unidirectionally connected to the camera (5) by the optical coupling (20) and it is also unidirectionally connected to the temperature measuring block (6) by the thermal coupling (18), whereby the disconnector for charging (2) is connected to the programmable power supply (7) by the power wires (15) and the disconnector for discharging (3) is connected to the programmable load (8) by the power wires (15);

and the control system (9) contains the control circuit (10), which is bi-directionally connected to the first communication block (12) and to the second communication block (13) by the data wires (17), and the control circuit (10) is bi-directionally connected to the computing unit (14) by the data wires (17), while the control circuit (10) is unidirectionally connected to the measuring block (11) by means of the data wires (17), and the control circuit (10) is unidirectionally connected to the disconnector for charging (2) and the disconnector for discharging (3) by the control wires (19);

and the camera (5) is unidirectionally connected to the computing unit (14) by the data wires (17), the accumulator under test (4) is unidirectionally connected to the measuring block (11) by the measuring wires (16), the temperature measuring block (6) is unidirectionally connected to the control circuit (10) by the data wires (17), the programmable power supply (7) is bi-directionally connected to the first communication block (12) via data wires (17), and the programmable load (8) is bi-directionally connected to the second communication block (13) via data wires (17).

The method for identifying the parameters of a substitute electrical scheme of accumulator (4) is also described.

EP 4 435 453 A1

Fig. 3

## Description

### Field of Technology

The present invention relates to an apparatus for identifying parameters of a substitute electrical scheme of accumulator, and a method for identifying parameters of the substitute electrical scheme of accumulator. The solution belongs to the field of power electronics.

### State of the Art

Nowadays, still more and more industry starts to adapt to coming of electromobility or focuses on production of renewable energy and its efficient use. For these reasons, the interest in accumulators increases enormously and as a result, accumulator development also grows rapidly. Use of new materials, development of new chemistries, management of accumulator energy or the maximization of accumulator safety open new opportunities for work in this field. Many manufacturers develop and supply new types of accumulators, new packs, or improve performance of accumulators through use of new materials and chemical compounds, as well as through structural design.

Accumulator manufacturers only list the basic parameters of their accumulators (nominal voltage and current, capacity, max. thermal load), but in the development of electronic systems it is necessary to know the specific parameters of the accumulator - the parameters of the substitute electrical scheme, which are usually not listed by the manufacturers. These are mainly the voltage of the unloaded cell, RC cells, as well as their thermal dependence.

From the data available from the manufacturer, in most cases only the maximum current load of the accumulator can be determined, while this parameter is directly linked to the internal resistance of the accumulator. However, the internal resistance of the accumulator is very rarely presented by the manufacturers and yet this parameter is very important in terms of the maximum load, since from the internal resistance we can see how much the temperature of the accumulator will vary. The internal resistance is also very important for safety of the accumulator itself. This parameter directly depends on the voltage drop of the accumulator, while this voltage must not fall below a safe minimum voltage level. Especially for lithium-based accumulators, a drop below this voltage is very critical, as lithium cells tend to burn or explode. For this reason, when developing accumulator applications, it is therefore also necessary to work with this parameter.

From the parameters of the substitute electrical scheme, it is possible to construct a simulation model of the accumulator, which is particularly advantageous for development of other electronic applications.

### Essence of the Invention

The aforementioned disadvantage - unfamiliarity with the parameters of the substitute equivalent scheme of accumulators and the need to identify them - is eliminated by the presented invention, a device for identifying the substitute electrical scheme of accumulators, which, on the basis of measurements from the specific charging and discharging process of the given accumulator, evaluates the parameters of the substitute electrical scheme depending on the state of charge.

The apparatus for identifying parameters of an accumulator substitute electrical scheme includes a measuring chamber, a programmable power supply, a programmable load, a control system, and a computing unit.

The computing unit is equipped for operator access to test process parameter settings, test status monitoring and test results, video recording of testing, as well as other data about the test equipment and the accumulator under test. The measuring chamber contains a disconnector for charging and a disconnector for discharging between which the tested accumulator is placed connected to them by means of power wires. The accumulator is connected to the camera by optical coupling and is connected to the temperature measuring block by thermal coupling. The disconnector for charging is connected to the programmable power supply by means of power wires and the disconnector for discharging is connected to the programmable load by power wires.

The control system includes a control circuit that is bi-directionally connected to the first communication block and the second communication block via data wires, and the control circuit is bi-directionally connected to the computing unit via data wires. The measuring block is unidirectionally connected to the control circuit via data wires.

The control circuit is unidirectionally connected to the disconnector for charging and the disconnector for discharging by means of control wires.

The camera is connected to the computing unit using data wires in one way, the tested accumulator is unidirectionally connected to the measuring block using measuring wires.

The temperature measuring block is unidirectionally connected to the control circuit via data wires. The programmable power supply is bi-directionally connected to the first communication block via data wires, and the programmable load is bi-directionally connected to the second communication block via data wires.

The method for identifying the parameters of the accumulator substitute electrical scheme by the above described apparatus is carried out by first treating the tested accumulator to be in a fully charged state or a fully discharged state, then the parameters of the test process given by the type and characteristics of the tested accumulator are inputted into the computing unit by the operator and set, and the temperature limit value of the tested accumulator is also set.

Then the tested accumulator is inserted into the measuring chamber between the disconnector for charging and the disconnector for discharging; it is connected to them via power wires. The temperature measuring block measures the operating temperature of the tested accumulator and transmits the data to the control circuit. A connected camera senses the charging and discharging process of the tested accumulator and transmits the collected data in the form of a video recording to the connected computing unit, which saves this recording.

If the tested accumulator was fully discharged at the beginning of the process, the programmable power supply charges the accumulator in a controlled manner; if the accumulator was fully charged at the beginning of the process, the programmable load discharges the accumulator in a controlled manner.

Via the first communication block and via the second communication block the control circuit enters charging and discharging parameters of the tested accumulator for the programmable power supply and for the programmable load. The measuring block measures accurate values of the operating voltages and currents during the charging and discharging cycles and is connected to the control circuit which is connected to the computing unit. The computing unit stores, processes and displays the measured data.

In the measuring process carried out during the short but rapid charging/discharging intervals and after the charging/discharging current reaches the set value, there is a pause that lasts until the voltage of the unloaded OCV cell settles at a constant value, and the charging process of the tested accumulator continues until the complete state of charge (100% SOC) or the discharging process continues until the complete state of discharge (0% SOC).

SOC = State of Charge.

After the measuring is completed, the data measured in the measuring block together with the data from the programmable power supply and programmable load measured during the charging and discharging process and also in the unloaded state of the tested accumulator are stored in the computing unit, which evaluates parameters of the substitute electrical scheme from the time constants obtained from charging and discharging process of the tested accumulator: the voltage of the unloaded cell, the parameters of RC cells and their thermal coefficient.

If the control circuit detects during testing that the pre-set allowable temperature of the accumulator under test has been exceeded, or the allowable charge/discharge current of the tested accumulator has been exceeded, an error condition occurs in which the disconnector for charging or the disconnector for discharging disconnects the tested accumulator.

If a fault or an emergency condition is confirmed during the re-measurement, the testing process is stopped for safety reasons and the tested accumulator is excluded from the testing.

The entire measuring process is controlled and monitored by the computing unit, which also provides input from the operator.

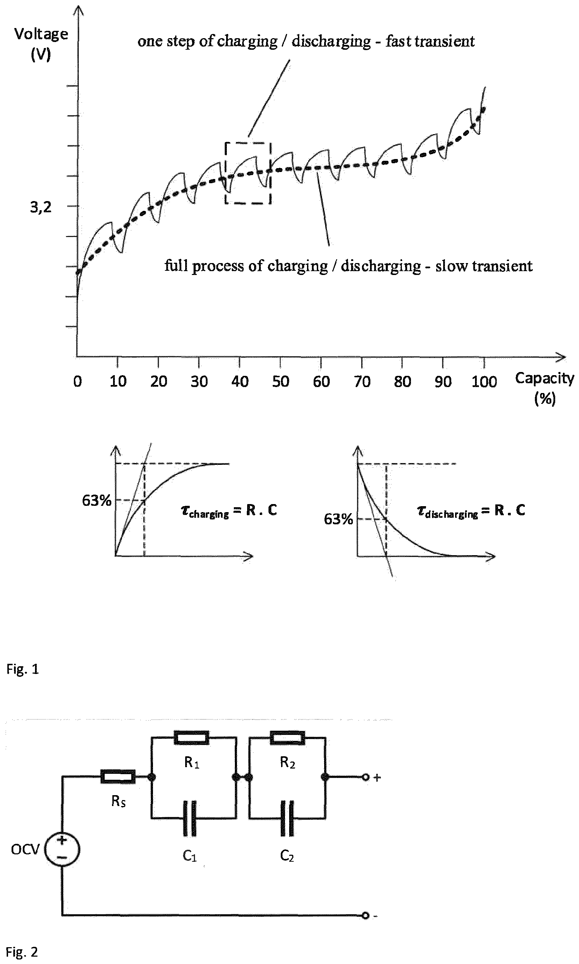

During the controlled charging and discharging process of the tested accumulator, the time constants of the tested accumulator are monitored. From the fast events, i.e. from a single charging and discharging step (see the highlighted detail in the box in Figure 1, parameters of the fast time constant $\tau_1$ (manifested as a gradual decrease in voltage under load and at the same time as a gradual increase in voltage under charge) are determined.

From the whole charging and discharging process of the tested accumulator (full charge and full discharge - see the highlighted waveform in Fig. 1) the parameters of the slow time constant $\tau_2$, the slow voltage recovery after charging as a slow drop and during discharging as shown in Fig. 1 are determined.

From the process of charging, we obtain the values of the time constants (for single short-fast events - highlighted box in Fig. 1) at different levels of the state of charge and the time constant for the whole charging process (slow event - full charge- see the highlighted waveform in Fig. 1). In the same way, we obtain the values of the time constants (for single short-fast events - highlighted box in Fig. 1, or full discharge - see highlighted waveform in Fig. 1 - for the whole discharge process. From the quiescent state, we obtain the voltage value of unloaded cell for a given state of charge.

From the values obtained, we create curves for:

- unloaded cell voltage values depending on state of charging/discharging and temperature coefficient,

- values of the fast time constants depending on the state of charging/discharging,

- values of the slow time constants depending on the state of charging/discharging,

The examples of such curves are shown in Fig. 1.

Then, from the obtained waveforms (both slow and fast, charging process and discharging process), we determine the voltage value of the unloaded cell and calculate the parameters: $R_S$, $R_1$, $C_1$, $R_2$, $C_2$ and $\alpha$ using the following relation:

$$\tau = R \cdot C$$

If an error condition is detected (exceeding the set parameters), the process is terminated.

Fig. 2 shows an equivalent scheme of the accumulator under test, where:

OCV - unloaded cell voltage

Rs - series internal resistance of the cell

$R_1$, $C_1$ - parameters of the fast time constant (manifested as a gradual decrease in voltage under load and at the same time as a gradual increase in voltage under charge)

$R_2$, $C_2$ - slow time constant parameters (slow voltage recovery after charging as a slow drop and when discharging)

$\alpha$ - temperature coefficient

The device for identifying the parameters of the substitute electrical scheme of the tested accumulator based on measurements from the charging and discharging process of a given accumulator - that is, from time constants obtained from the charging and discharging process of a given accumulator, evaluates parameters of the equivalent substitute scheme of the tested accumulator with an accuracy of maximum 5 % relative error.

Subsequently, based on the evaluated parameters of the equivalent substitute scheme, outputs are prepared. These can be presented in the form of a table, or a simulation model of the tested accumulator can be constructed.

Thanks to use of a camera that senses the tested accumulator, the entire control and evaluation can also be carried out remotely.

**Short description of figures**

Fig. 1 shows examples of the curve for:

- voltage values of the unloaded cell depending on the state of charging/discharging,

- values of the fast time constants depending on the state of charging/discharging,

- values of the slow time constants depending on the state of charging/discharging

Fig. 2 shows an equivalent scheme of the tested accumulator

Fig. 3 shows a block diagram of the system for identifying the parameters of the accumulator substitute electrical scheme

Fig. 4 shows an example of data output in the form of a model

Fig. 5a shows the testing method in the form of a flow chart in case when starting from the "full discharge" state of the tested accumulator

Fig. 5b shows the testing method in the form of a flow chart in case when starting from the "full charge" state of the tested accumulator

**Examples**

**Example 1**

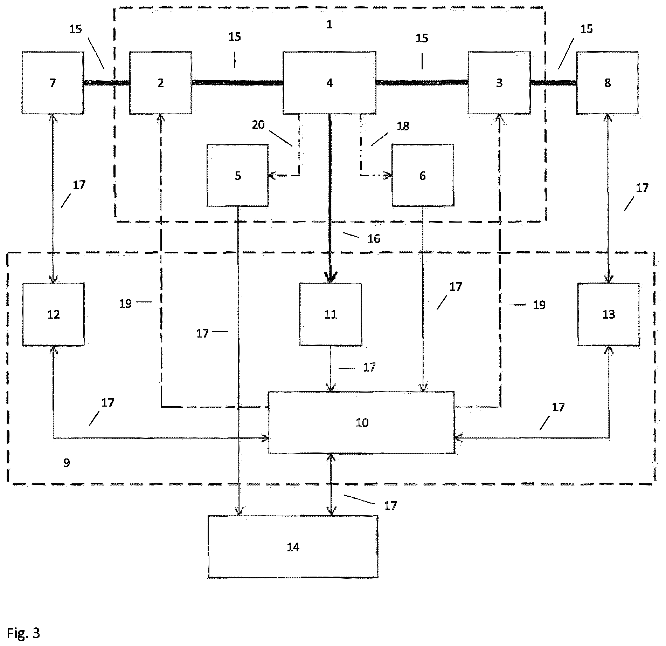

The apparatus for identifying the parameters of the accumulator substitute electrical scheme according to Fig. 3 consists of a measuring chamber 1, a programmable power supply 7, a programmable load 8, a control system 9 and a computing unit 14.

The measuring chamber 1 comprises a disconnector 2 for charging and a disconnector 3 for discharging between which a tested accumulator 4 is placed connected thereto by means of power wires 15. The tested accumulator 4 is connected unidirectionally to the camera 5 by optical coupling 20 and is connected unidirectionally to the temperature measuring block 6 by thermal coupling 18. The disconnector for charging 2 is connected to the programmable power supply 7 by power wires 15, and the disconnector for discharging 3 is connected to the programmable load 8 by power wires 15.

The control system 9 consists of the control circuit 10, which is bi-directionally connected to the first communication block 12 and the second communication block 13 via the data wires 17. The control circuit 10 is bi-directionally connected to the computing unit 14 via the data wires 17. The control circuit 10 is unidirectionally connected to the measuring block 11 by the data wires 17, and the control circuit 10 is unidirectionally connected to the disconnector for charging 2 and the disconnector for discharging 3 by the control wires 19.

The camera 5 is unidirectionally connected to the computing unit 14 by the data wires 17. The tested accumulator 4 is connected unidirectionally to the measuring block 11 by the measuring wires 16, and the temperature measuring block 6 is connected unidirectionally to the control circuit 10 by the data wires 17. The programmable power supply 7 is bi-directionally connected to the first communication block 12 by the data wires 17, and the programmable load 8 is bi-directionally connected to the second communication block 13 by the data wires 17.

The computing unit 14 is arranged for operator access to set the parameters of the testing process, to monitor the status of the testing, and to access the results of the testing, the video recording of the testing, as well as other data about the testing device and the tested accumulator 4.

The testing method is as follows:

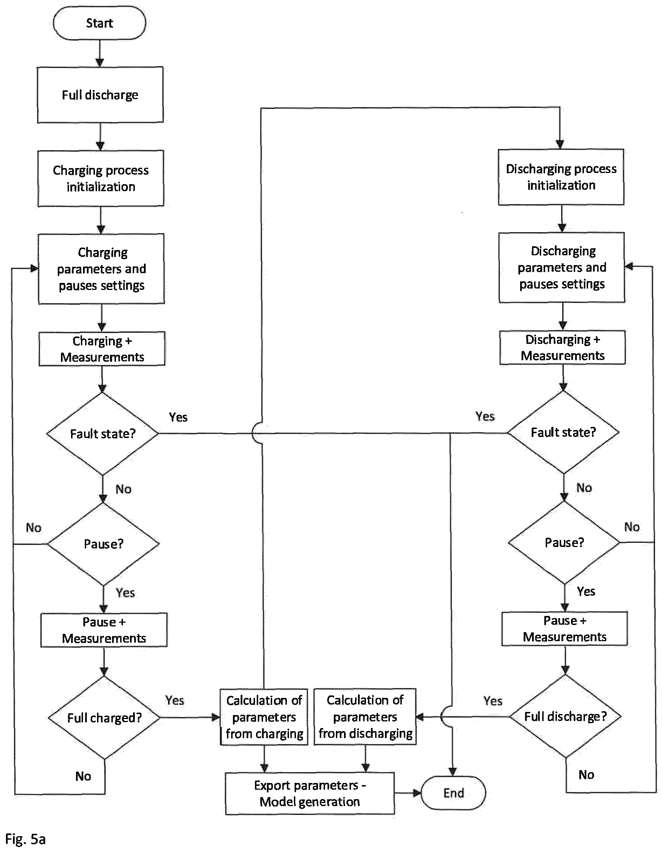

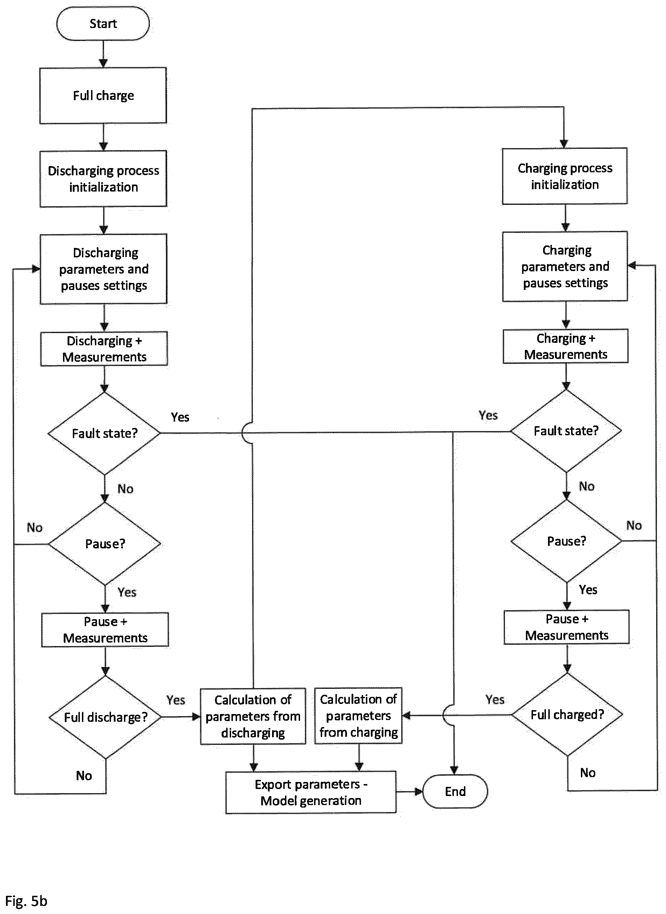

- the tested accumulator 4 is first treated to be in a fully charged state or a fully discharged state as shown in Fig. 5a and 5b in the form of a flow diagram. Then the parameters of the testing process given by the type and characteristics of the tested accumulator 4 are entered into the computing unit 14 by the operator and set, while the temperature limit value of the tested accumulator 4 is also set.

Then, the tested accumulator 4 is inserted into the measuring chamber 1 between the disconnector for charging 2 and the disconnector for discharging 3 and connected to them by the power wires 15. The temperature measuring block 6 measures the operating temperature of the accumulator 4 and transmits the data to the control circuit 10. The connected camera 5 senses the charging and discharging process of the accumulator 4 and transmits the collected data in the form of a video recording to the connected computing unit 14, which saves this recording.

- if the tested accumulator 4 is fully discharged at the beginning of the process, the programmable power supply 7 charges the tested accumulator 4 in a controlled manner as shown in Fig. 5a

- if the tested accumulator 4 is fully charged at the beginning of the process, the programmable load 8 discharges the tested accumulator 4 in a controlled manner as shown in Fig. 5b

- via the first communication block 12 and the second communication block 13, the control circuit 10 enters the charging and discharging parameters of the tested accumulator 4 for the programmable power supply 7 and for the programmable load 8. The measuring block 11 measures the exact values of the operating voltages and currents during the charging and discharging cycles. It is connected to the control circuit 10, which is connected to the computing unit 14 that stores, processes and displays the measured data.

- during the measuring process carried out during the short but rapid charging/discharging intervals and after the charging/discharging current reaches the set value, there is a pause that lasts until the voltage of the unloaded OCV cell settles at a constant value, and the charging process of the accumulator under test continues until the complete state of charge (100% SOC) or the discharging process continues until the complete state of discharge (0% SOC).

- after the measuring is completed, the data measured in the measuring block 11 together with the data from the programmable power supply 7 and the programmable load 8 measured during the charging and discharging process and also in the unloaded state of the tested accumulator 4 are stored in the computing unit 14, which evaluates parameters of the substitute electrical scheme from the time constants obtained from charging and discharging process of the tested accumulator 4: the voltage of the unloaded cell, the parameters of RC cells and their thermal coefficient.

- If the control circuit 10 detects during testing that the pre-set allowable temperature of the tested accumulator 4 has been exceeded, or the allowable charge/discharge current of the tested accumulator 4 has been exceeded, an error condition occurs in which the disconnector for charging 2 or the disconnector for discharging 3 disconnects the tested accumulator 4.

If a fault or an emergency condition is confirmed during the re-measurement, the testing process is stopped for safety reasons and the accumulator 4 is excluded from testing.

- the entire measuring process is controlled and monitored by the computing unit 14, which also provides inputs from the operator.

The outputs are presented in the form of a table:

Tab. 1.

| Parameter | Value | Unit |
|---|---|---|
| Unloaded OCV cell voltage | V | V |
| $R_s$ | | $m\Omega$ |
| $C_1$ | | F |
| $R_1$ | | $m\Omega$ |
| $C_2$ | | F |
| $R_2$ | | $m\Omega$ |
| $\alpha$ | | $°C^{-1}$ |

The parameters of the substitute electrical scheme evaluated and supplied by the computing unit 14 include the voltage of the unloaded cell, the parameters of the RC cells and their temperature coefficient.

**Example 2**

The device and procedure as in Example 1, except that the tested accumulator 4 is lithium-based. The computing unit 14 evaluates the parameters of the equivalent substitute scheme of the tested accumulator 4 with an accuracy of no more than 5 % relative error. The outputs are presented in the form of a table.

**Example 3**

The device is versatile; it allows you to test all 4 types of accumulators. In this example, NiCd, NiMh accumulators are tested. The device and testing procedure is the same as in Example 1. The outputs are presented in the form of a table.

**Example 4**

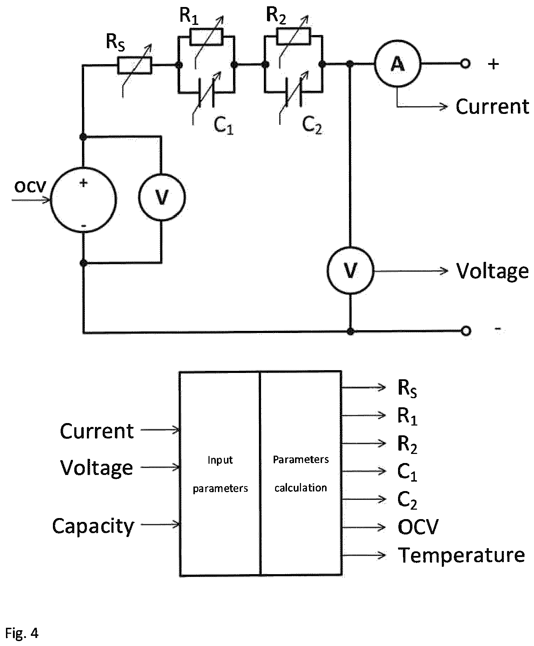

The device and procedure as in Example 1, except that from the parameters of the substitute electrical scheme, the computing unit 14 generates a simulation model of the given tested accumulator 4 as shown in Fig. 4.

The tested accumulator 4 is lead-based.

**Example 5**

The device and procedure as in Example 1, except that the tested accumulator 4 is first placed in the measuring chamber 1, which is connected to the disconnector for charging 2 and to the disconnector for discharging 3 by the power wires 15. The accumulator 4 is unidirectionally connected to the camera 5 by the optical coupling 20 and it is unidirectionally connected to the temperature measuring block 6 by the thermal coupling 18. Then, the whole process of identifying the parameters of the equivalent scheme of the tested accumulator 4 is already carried out remotely via the camera 5. Such a procedure is particularly advantageous from a safety point of view in case there is a risk of fire/explosion during the parameter measurement.

The computing unit 14 generates a simulation model of the given accumulator 4.

**Industrial Applicability**

Nowadays, it is possible to use the device to identify the parameters of the substitute accumulator electrical scheme in various industries. In particular, the development of electromobility, renewable energy sources and the development of new technologies have led to a significant boom in accumulator development and production. For development of the systems in question, it is necessary to know parameters of the accumulator used, what is possible by the presented invention. The device for identifying parameters of the substitute electrical scheme of the accumulator determines the parameters of the substitute electrical scheme, based on which a simulation model of the accumulator in question can be constructed, this fact is very important in terms of development of further applications. Thanks to use of the camera that senses the electrochemical cell under test, this evaluation can also be carried out and controlled remotely.

**Claims**

1. Apparatus for identifying parameters of a substitute electrical scheme of accumulators **characterised in that** it contains a measuring chamber (1), a programmable power supply (7), a programmable load (8), a control system (9), and a computing unit (14),

while the computing unit (14) is equipped for operator access to set the parameters of the testing process, to monitor the status of the testing, and to access the results of the testing, the video recording of the testing, as well as other data about the testing apparatus and the accumulator under test (4);

and the measuring chamber (1) contains a disconnector (2) for charging and a disconnector (3) for discharging between which a accumulator under test (4) is placed connected thereto by power wires (15), and the accumulator under test (4) is unidirectionally connected to the camera (5) by the optical coupling (20) and it is also unidirectionally connected to the temperature measuring block (6) by the thermal coupling (18), whereby the disconnector for charging (2) is connected to the programmable power supply (7) by the power wires (15) and the disconnector for discharging (3) is connected to the programmable load (8) by the power wires (15);

and the control system (9) contains the control circuit (10), which is bi-directionally connected to the first communication block (12) and to the second communication block (13) by the data wires (17), and the control circuit (10) is bi-directionally connected to the computing unit (14) by the data wires (17), while the control circuit (10) is unidirectionally connected to the measuring block (11) by means of the data wires (17), and the control circuit (10) is unidirectionally connected to the disconnector for charging (2) and the disconnector for discharging (3) by the control wires (19);

and the camera (5) is unidirectionally connected to the computing unit (14) by the data wires (17), the accumulator under test (4) is unidirectionally connected to the measuring block (11) by the measuring wires (16), the temperature measuring block (6) is unidirectionally connected to the control circuit (10) by the data wires (17), the programmable power supply (7) is bi-directionally connected to the first communication block (12) via data wires (17), and the programmable load (8) is bi-directionally connected to the second communication block (13) via data wires (17).

2. Method for identifying the parameters of the accumulator substitute electrical scheme by apparatus according the claim 1 **characterized in that** in the first step, the tested accumulator (4) is treated to achieve the status either to be in a fully charged state or in a fully discharged state, then the parameters of the test process given by the type and characteristics of the tested accumulator (4) are inputted into the computing unit (14) by the operator and set, while the temperature limit value of the tested accumulator

(4) is also set,

then the tested accumulator (4) is inserted into the measuring chamber (1) between the disconnector (2) for charging and the disconnector (3) for discharging and connected to them by the power wires (15); the temperature measuring block (6) measures the operating temperature of the tested accumulator (4) and transmits the data to the control circuit (10); the connected camera (5) senses the charging and discharging process of the tested accumulator (4) and transmits the collected data in the form of a video recording to the connected computing unit (14), which saves this recording; if the tested accumulator (4) was fully discharged at the beginning of the process, the programmable power supply (7) charges the accumulator (4) in a controlled manner; if the accumulator (4) was fully charged at the beginning of the process, the programmable load (8) discharges the accumulator (4) in a controlled manner; the control circuit (10) inputs the charging and discharging parameters of the accumulator (4) to the programmable power supply (7) and to the programmable load (8) via the first communication block (12) and the second communication block (13), while the measuring block (11) measures the exact values of the operating voltages and currents during the charging and discharging cycles and the measuring block (11) is connected to the control circuit (10) which is connected to the computing unit (14) which stores, processes and displays the measured data;

while in the measuring process, during the short but rapid charging/discharging intervals, and after the charging/discharging current reaches the pre-set value, there is a pause, that lasts until the voltage of the unloaded OCV cell settles at a constant value, and the charging process of the accumulator (4) continues until the complete state of charge (100% SOC), or the discharging process continues until the complete state of discharge (0% SOC);

and after the measuring is completed, the data measured in the measuring block (11) together with the data from the programmable power supply (7) and the programmable load (8) measured during the charging and discharging process and also in the unloaded state of the tested accumulator (4) are stored in the computing unit (14), which evaluates parameters of the substitute electrical scheme from the time constants obtained from charging and discharging process of the tested accumulator (4): the voltage of the unloaded cell, the parameters of RC cells and their thermal coefficient;

while if the control circuit (10) detects during testing that the pre-set allowable temperature of the accumulator (4) has been exceeded, or the allowable charge/discharge current of the accumulator (4) has been exceeded, occurs error condition, in which the disconnector (2) for charging or the disconnector (3) for discharging disconnects the tested accumulator (4), while if a fault or an emergency condition is confirmed during the re-measurement, the testing process is stopped for safety reasons and the tested accumulator (4) is excluded from testing,

and the entire measuring process is controlled and monitored by the computing unit (14), which also provides inputs from the operator.

3.  The method for identifying parameters of the substitute electrical scheme of the accumulator according to claim 2 **characterized in that** from the parameters of the substitute electrical scheme the computing unit (14) generates a simulation model of the tested accumulator (4).

4.  The method for identifying the parameters of the substitute electrical scheme of the accumulator according to claim 2 **characterized in that** after inserting the tested accumulator (4) into the measuring chamber (1) between the disconnector (2) for charging and the disconnector (3) for discharging is the whole process of identifying the equivalent scheme parameters of the tested accumulator (4) further carried out remotely by means of the camera (5).

5.  The method for identifying the parameters of the substitute electrical scheme of the accumulator according to claims 1-4 **characterized in that** the tested accumulator (4) is lithium-based.

6.  The method for identifying the parameters the substitute electrical scheme of the accumulator according to claim 5 **characterized in that** the computing unit (14) evaluates the parameters of the equivalent substitute scheme of the tested accumulator (4) with an accuracy of maximum 5 % relative error.

Fig. 1

Fig. 2

Fig. 3

Fig. 4

Fig. 5a

Fig. 5b

Europäisches
Patentamt

European
Patent Office

Office européen
des brevets

# EUROPEAN SEARCH REPORT

Application Number

EP 23 16 4181

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/200071 A1 (KO JEONGSIK [KR] ET AL) 23 June 2022 (2022-06-23) | 1 | INV. G01R31/392 G01R31/36 |
| Y | * abstract; figures 1-13 * * paragraphs [0003] - [0007], [0014], [0050] - [0051], [0108] * | 2-6 | |
| X | US 2018/284197 A1 (CUI CHENGWU [US] ET AL) 4 October 2018 (2018-10-04) * abstract; figures 5a-8 * * paragraphs [0030], [0031], [0069] - [0073] * | 1 | |
| Y | SIMCAK MAREK ET AL: "Evaluation of accuracy of simulation model and real electrochemical cell based on LiFePO4 chemistry", 2022 ELEKTRO (ELEKTRO), IEEE, 23 May 2022 (2022-05-23), pages 1-7, XP034140411, DOI: 10.1109/ELEKTRO53996.2022.9803577 [retrieved on 2022-06-27] * the whole document * | 2-6 | TECHNICAL FIELDS SEARCHED (IPC) G01R |

The present search report has been drawn up for all claims

| Place of search | Date of completion of the search | Examiner |
|---|---|---|
| Munich | 15 September 2023 | Kleiber, Michael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 16 4181

This annex lists the patent family members relating to the patent documents cited in the above-mentioned European search report.
The members are as contained in the European Patent Office EDP file on
The European Patent Office is in no way liable for these particulars which are merely given for the purpose of information.

15-09-2023

| Patent document cited in search report | | | Publication date | Patent family member(s) | | | Publication date |
|---|---|---|---|---|---|---|---|
| US 2022200071 | A1 | | 23-06-2022 | CN | 114646879 | A | 21-06-2022 |
| | | | | EP | 4016100 | A1 | 22-06-2022 |
| | | | | KR | 20220086831 | A | 24-06-2022 |
| | | | | US | 2022200071 | A1 | 23-06-2022 |
| US 2018284197 | A1 | | 04-10-2018 | CN | 110651193 | A | 03-01-2020 |
| | | | | CN | 115015774 | A | 06-09-2022 |
| | | | | EP | 3602090 | A1 | 05-02-2020 |
| | | | | JP | 6892728 | B2 | 23-06-2021 |
| | | | | JP | 2020516020 | A | 28-05-2020 |
| | | | | US | 2018284197 | A1 | 04-10-2018 |
| | | | | US | 2019331740 | A1 | 31-10-2019 |
| | | | | WO | 2018183046 | A1 | 04-10-2018 |

EPO FORM P0459

For more details about this annex : see Official Journal of the European Patent Office, No. 12/82